# EUROPÄISCHE PATENTANMELDUNG

(11) **EP 0 633 330 A1**
(43) Veröffentlichungstag der Anmeldung: **11.01.1995**
(21) Anmeldenummer: 94109765.1
(22) Anmeldetag: 24.06.1994
(51) Int. Cl.: C25D 17/06, H05K 3/24

(54) **Kontaktiereinrichtung für ein Leiterplattengestell einer Galvanikanlage**

(30) Priorität: 01.07.1993 DE 9309768 U
(71) Anmelder: METZKA GmbH, D-90596 Schwanstetten (DE)
(72) Erfinder: Metzka, Hans Joachim, D-90473 Nürnberg (DE)
(74) Vertreter: Segeth, Wolfgang

(57) **Zusammenfassung**

Es wird eine Kontaktiereinrichtung (22) für ein Leiterplattengestell einer Galvanikanlage beschrieben, wobei die Kontaktiereinrichtung (22) zur Kontaktierung einer entsprechenden Leiterplatte (20) mit Kontaktorganen ausgebildet ist. Die Kontaktiereinrichtung (22) weist zwei voneinander beabstandete Stangenelemente (24,26) auf, die miteinander durch Abstandselemente (28) verbunden sind. Das erste Stangenelement (24) ist mit Kontaktschellen (34) versehen, von welchen erste Kontaktorgane wegstehen. Vom zweiten Stangenelement (26) stehen in Richtung zum ersten Stangenelement (24) hin Federelemente (42) weg, von welchen jedes mit mindestens einem zweiten Kontaktorgan versehen ist. Zusammengehörende Kontaktorgan-Paare werden mit ihren Kontaktflächen (40, 58) mittels des zugehörigen Federelementes (42) gegeneinandergedrückt.

## Beschreibung

Die Erfindung betrifft eine für ein Leiterplattengestell einer Galvanikanlage vorgesehene Kontaktiereinrichtung mit Kontaktorganen zur Kontaktierung einer Leiterplatte.

Im DE-GM 89 10 413 der Azimelderin sind derartige, als sogenannte Drehstabgestelle bezeichnete Halte- bzw. Kontaktiereinrichtungen beschrieben. Solche Drehstabgestelle sind auch im Prospekt der Anmelderin "...modernste Leiterplatten-Produktion mit Roboter-Konzept" beschrieben und dargestellt. Derartige Drehstabgestelle lassen jedoch insbesondere bzgl. ihrer Reparaturfreundlichkeit noch Wünsche offen.

Die DE 30 27 751 C2 offenbart eine Vorrichtung zum galvanischen Metallisieren von Substraten mit einem nichtleitenden, beständigen und insbesondere U-förmigen Halterahmen zum stabilen Halten der Substrate im Elektrolyten und Ankontaktieren an einer kathodisch geschalteten Kontaktschiene. Dort ist ein Profilrahmen zur Aufnahme von ein oder mehreren Substraten vorgesehen, den oben die leitende Kontaktschiene und parallel dazu ein nichtleitender Substratanschlag überbrücken. Ferner sind zwischen der Kontaktschiene und dem Substratanschlag Klauen zum Ankontaktieren der Substrate befestigt. Außerdem sind oben an der Kontaktschiene zum leitenden Befestigen des Profilrahmens verstellbare Halterungen angebracht und ist die für die Aufnahme der Substrate dienende Innenseite des Profilrahmens an der Vorder- und Rückseite zumindest teilweise durch Blenden abgedeckt. Diese Vorrichtung weist also eine Vielzahl Einzelteile auf, was sich auf die Manipulation bzw. Betätigung dieser Vorrichtung auswirkt.

Eine Vorrichtung zum Abblenden von Feldlinien in einer Galvanikanlage zur Behandlung von im wesentlichen plattenförmigen Werkstücken wie Leiterplatten, die an einem Warenträger hängend in ein Bad eingebracht werden, wobei eine in Vertikalrichtung verstellbar am Badbehälter geführte Blende vorgesehen ist, ist aus der DE 40 05 209 C2 bekannt. Bei dieser Vorrichtung ist am Warenträger ein Niederhalter höhenverstellbar und in der jeweiligen Stelllage fixierbar angebracht, der die seitlich der zu galvanisierenden Werkstücke angeordneten Blenden beim Einbringen des Warenträgers in die Behandlungsstation in eine vorgewählte Position bewegt.

Der Erfindung liegt die Aufgabe zugrunde, eine Kontaktiereinrichtung der eingangs genannten Art zu schaffen, die mechanisch stabil und robust ist, die einfach betätigbar ist, und die insbesondere äußerst reparaturfreundlich ist.

Diese Aufgabe wird erfindungsgemäß dadurch gelöst, daß die Kontaktiereinrichtung zwei voneinander beabstandete Stangenelemente aufweist, die miteinander durch Abstandselemente verbunden sind, daß das eine der Stangenelemente mit Kontaktschellen versehen ist, von welchen erste Kontaktorgane wegstehen und das vom zweiten Stangenelement in Richtung zum ersten Stangenelement hin Federelemente wegstehen, von welchen jedes mit mindestens einem zweiten Kontaktorgan versehen ist, wobei zusammengehörende Kontaktorgane-Paare mit ihren Kontaktflächen mittels des zugehörigen Federelementes gegeneinander gedrückt werden. Eine solche Kontaktiereinrichtung ist mechanisch sehr stabil und robust, wobei sich durch die Federelemente eine sichere und zuverlässige Kontaktierung einer entsprechenden Leiterplatte ergibt.

Als vorteilhaft hat es sich erwiesen, wenn das erste Stangenelement einen Kern aus einem elektrisch gut leitenden Material und eine am Kern eng anliegende Hülle aus chemisch beständigem Material aufweist. Zweckmäßigerweise besteht der Kern aus Kupfer und die den Kern umschließende Hülle aus V4A-Edelstahl.

Das erste Stangenelement besitzt vorzugsweise einen kreisrunden Querschnitt und jede Kontaktschelle ist zweckmäßigerweise als am ersten Stangenelement elektrisch leitende fixierte Hülse ausgebildet, von der tangential das entsprechende erste Kontaktorgan als Lasche wegsteht, die mit der zugehörigen Kontaktfläche ausgebildet ist. Die als Hülse ausgebildete Kontaktschelle ist vorzugsweise am ersten Stangenelement festgeschweißt. Deshalb ist es zweckmäßig, die besagte Kontaktschelle aus demselben Material herzustellen wie die den elektrisch leitenden Kern umgebende Hülle des ersten Stangenelementes. Die Kontaktschelle kann also beispielsweise ebenfalls aus V4A-Edelstahl bestehen.

Die/jede Lasche ist vorzugsweise auf der dem entsprechenden Federelementen zugewandten Seite mit einer die Kontaktfläche aufweisenden Erhebung ausgebildet. Die Erhebung kann an der Lasche einstückig angeformt sein, es ist jedoch auch möglich, die Erhebung an der Lasche beispielsweise festzuschweißen. Die Lasche mit der Erhebung kann ebenfalls aus V4A-Edelstahl sein.

Vorteilhaft ist es, wenn die/jede Lasche auf der vom zweiten Stangenelement abgewandten Seite vom ersten Stangenelement wegsteht, weil hierdurch ein relativ großer Federweg des Federelementes und folglich der Kontaktorgane realisierbar ist. Hierdurch sind die Federungseigenschaften und demzufolge die Kontakt- bzw. Presskraft zwischen den Kontaktorganen des entsprechenden Kontaktorgan-Paares wunschgemäß festlegbar.

Eine einfache Ausbildung der erfindungsgemäßen Kontaktiereinrichtung ergibt sich, wenn das/jedes Federelement ein Federblech ist, von dem mindestens ein das entsprechende zweite Kontaktorgan bildender Stift wegsteht, dessen vom Federblech entfernte Stirnfläche die entsprechende Kontaktfläche bildet. Das Federblech besteht bspw. aus einem handelsüblichen Federstahl, an welchem der das entsprechende zweite Kontaktorgan bildende Stift festgenietet oder vorzugsweise festgeschweißt ist.

Eine ausgezeichnete Reparaturfreundlichkeit der erfindungsgemäßen Kontaktiereinrichtung ergibt sich, wenn das/jedes Federblech am zweiten Stangenelement festgeschraubt ist.

Die weiter oben erwähnten optimalen Federungseigenschaften der erfindungsgemäßen Kontaktiereinrichtung können erfindungsgemäß noch dadurch weiter verbessert werden, daß das/jedes Federblech an einem vom ersten Stangenelement abgewandten Befestigungsabschnitt des zweiten Stangenelementes festgeschraubt ist und mit seinem vom besagten Befestigungsabschnitt abgewandten freien Endabschnitt, von dem mindestens ein Kontaktstift zum zugehörigen Kontaktorgan des ersten Stangenelementes hin wegsteht, über die vom zweiten Stangenelement abgewandte Seite des ersten Stangenelementes vorsteht. Hierdurch ergibt sich nämlich eine relativ große Distanz zwischen dem Befestigungsabschnitt und dem freien Endabschnitt des Federelementes und folglich ein relativ großer Federweg für das mindestens eine zum zweiten Stangenelement zugehörige zweite Kontaktorgan.

Eine problemlose Befestigung des/jedes Federblechs am zweiten Stangenelement ergibt sich, wenn das zweite Stangenelement einen viereckigen Vollquerschnitt aufweist. Hierdurch ergibt sich außerdem eine gute mechanische Festigkeit und Formstabilität der erfindungsgemäßen Kontaktiereinrichtung, wenn das zweite Stangenelement mit der einen seiner beiden Diagonalen zum ersten Stangenelement hin orientiert ist.

Als vorteilhaft hat es sich erwiesen, wenn das Federelement zum Beabstanden der Kontaktorgane des entsprechenden Kontaktorgan-Paares mit einem Betätigungsorgan ausgebildet ist. Das besagte Betätigungsorgan kann ein Stift sein, der am Federblech zwischen dem ersten und dem zweiten Stangenelement befestigt ist und auf der vom Federblech abgewandten Seite über die beiden Stangenelemente übersteht. Dadurch ist das Betätigungsorgan gut zugänglich und somit einfach betätigbar.

Die Kontaktiereinrichtung ist mit Ausnahme der Kontaktflächen der Kontaktorgane vorzugsweise mit einer elektrisch isolierenden Beschichtung versehen. Diese Beschichtung ist chemisch resistent, so daß sich eine lange Standzeit der Kontaktiereinrichtung ergibt. Durch die besagte Beschichtung wird außerdem ein Verschleppen von Badsubstanz von einem zu einem anderen Bad verhindert. Erfindungsgemäß wird dabei vorzugsweise das Gebilde aus den beiden Stangenelementen und den die beiden Stangenelemente miteinander verbindenden Abstandselementen und den am ersten Stangenelement vorgesehenen Kontaktschellen mit den zugehörigen Laschen beschichtet, wobei aus der Beschichtung nur die entsprechenden Kontaktflächen blank herausstehen. Desgleichen wird jedes Federelement mit dem mindestens einen das entsprechende zweite Kontaktorgan bildenden Stift mit Ausnahme der Stirnfläche des entsprechenden Stiftes beschichtet. Bei dieser Beschichtung kann es sich um eine elektrostatische Beschichtung, um eine Wirbelbeschichtung oder dergleichen handeln.

Weitere Einzelheiten, Merkmale und Vorteile ergeben sich aus der nachfolgenden Beschreibung eines in der Zeichnung dargestellten Ausführungsbeispieles der erfindungsgemäßen Kontaktiereinrichtung. Es zeigen:
- Fig. 1: eine Kontaktiereinrichtung in Verbindung mit wesentlichen Teilen einer Galvanisierstation einer Galvanikanlage, und
- Fig. 2: einen Schnitt entlang der Schnittlinie II-II in Fig. 1 durch die erfindungsgemäße Kontaktiereinrichtung.

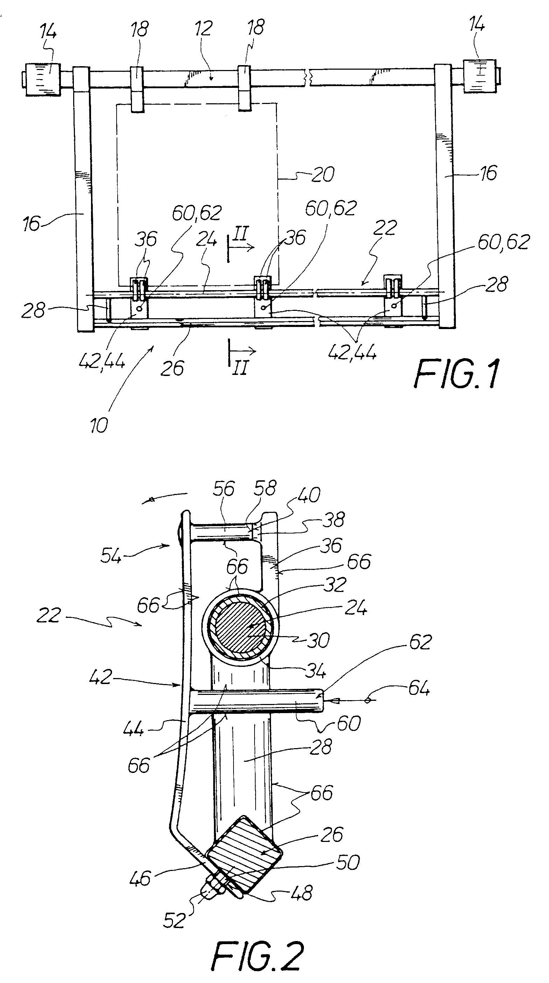

Fig. 1 zeigt in einer Seitenansicht eine Vorrichtung 10 mit einem Warenträger 12, der an Kontaktblöcken 14 vorgesehen ist, und von dem Verbindungselemente 16 und Halterungen 18 nach unten stehen. Die Halterungen 18 dienen zur Lokalisierung von Leiterplatten, von welchen in Fig. 1 eine mit dünnen strichlierten Linien angedeutet und mit der Bezugsziffer 20 bezeichnet ist.

Auf der vom Warenträger 12 entfernten Unterseite sind die Verbindungselemente 16 miteinander mittels einer Kontaktiereinrichtung 22 elektrisch leitend und mechanisch fest verbunden. Die Kontaktiereinrichtung 22 wird nachfolgend in Verbindung mit Fig. 2 detaillierter beschrieben. Sie weist ein erstes Stangenelement 24 und ein zweites Stangenelement 26 auf, die voneinander beabstandet zueinander parallel vorgesehen sind. Die beiden Stangenelemente 24 und 26 sind miteinander durch Abstandselemente 28 mechanisch fest verbunden.

Das erste Stangenelement 24 weist einen Kern 30 aus elektrisch leitendem Material, vorzugsweise aus Kupfer, auf. Der Kern 30 ist von einer Hülle 32 umgeben, die am Kern 30 eng anliegt. Die Hülle 32 besteht beispielsweise aus V4A-Edelstahl.

Das erste Stangenelement 24 ist mit Kontaktschellen 34 versehen, die an der Hülle 32 festgeschweißt sind. Die Kontaktschellen 34 können ebenfalls aus V4A-Edelstahl bestehen. Jede Kontaktschelle 34 weist eine Lasche 36 auf, die mit der Kontaktschelle 34 einstückig ausgebildet oder an dieser beispielsweise festgeschweißt sein kann. Die Lasche besteht folglich beispielsweise ebenfalls aus V4A-Edelstahl. Die vom ersten Stangenelement 24 tangential wegstehende Lasche 36 ist mit einer Erhebung 38 ausgebildet, deren von der Lasche 36 abgewandte Stirnfläche eine Kontaktfläche 40 bildet. Die Kontaktfläche 40 dient zur elektrisch leitenden Kontaktierung einer Leiterplatte 20 (sh. Fig. 1).

Um die zu metallisierende Leiterplatte 20 an der Kontaktiereinrichtung 22 zuverlässig fixieren und gleichzeitig elektrisch leitend kontaktieren zu können, weist die Kontaktiereinrichtung 22 Federelemente 42 auf, die jeweils aus einem Federblech 44 aus Federstahl gebildet sind. Das entsprechende Federblech 44 weist einen Befestigungsrandabschnitt 46 mit mindestens einem Durchgangsloch 48 auf. Das Federelement 42 ist am zweiten Stangenelement 26 dadurch mechanisch fest angeordnet, daß von dem einen viereckigen bzw. quadratischen Vollquerschnitt besitzenden zweiten Stangenelement 26 mindestens ein Gewindestift 50 wegsteht, der sich durch das zugehörige Durchgangsloch 48 im Befestigungsrandabschnitt 46 des Federbleches 44 hindurcherstreckt. Das Federblech 44 wird mittels einer mit dem entsprechenden Gewindestift 50 verschraubten Schraubmutter 52 am zweiten Stangenelement 26 befestigt, so daß sich eine gute Reparaturfreundlichkeit ergibt.

An dem vom Befestigungsrandabschnitt 46 des Federbleches 44 entfernten freien Endabschnitt 54 steht vom Federblech 44 des Federelementes 42 mindestens ein Stift 56 weg, wobei die Anzahl der Stifte 56 der Anzahl eng nebeneinander angeordneter Kontaktschellen 34 mit Laschen 36 entspricht, um entsprechende Kontakt-Paare zu bilden. Zu diesem Zweck ist jeder Kontaktstift 56 mit einer zur Kontaktfläche 40 zugehörigen und an dieser in der Nichtgebrauchsstellung der Kontaktiereinrichtung 22 eng anliegenden Kontaktfläche 58 ausgebildet. Die Kontaktflächen 40 und 58 werden mit Hilfe des Federelementes 42 gegeneinander gepreßt, was dadurch unterstützt werden kann, daß das Federblech 44 zwischen seinem freien Endabschnitt 54 und dem Befestigungsrandabschnitt 46 zu den beiden Stangenelementen 24 und 26 hin aufgewölbt ist. Vom Federblech 44 steht in einen mittleren Bereich zwischen den beiden Stangenelementen 24 und 26 ein als Stift 60 ausgebildetes Betätigungsorgan 62 weg. Wird das Betätigungsorgan 62 in Richtung des Pfeiles 64 betätigt, so werden die Kontaktflächen 40 und 58 voneinander beabstandet, so daß zwischen ihnen eine zu metallisierende Leiterplatte 20 (sh. Fig. 1) angeordnet werden kann. Wird die besagte Betätigung des Betätigungsorganes 62 danach aufgehoben, so entspannt sich das Federelement 42, wodurch die Kontaktflächen 40 und 58 an den entsprechenden Stellen der zu metallisiernden Leiterplatte 20 elektrisch leitend, d.h. kontaktierend zur Anlage kommen und die Leiterplatte 20 zwischen sich festklemmen.

Die Kontaktiereinrichtung 22 ist mit Ausnahme der besagten Kontaktflächen 40 und 58 und mit Ausnahme der Gewindestifte 50 und der Innengewindeabschnitte der Schraubmutter 52 allseitig mit einer elektrisch isolierenden Beschichtung 66 bedeckt.

## Patentansprüche

1. Für ein Leiterplattengestell einer Galvanikanlage vorgesehene Kontaktiereinrichtung (22) mit Kontaktorganen zur Kontaktierung einer Leiterplatte (20),
**dadurch gekennzeichnet,**
daß die Kontaktiereinrichtung (22) zwei voneinander beabstandete Stangenelemente (24, 26) aufweist, die miteinander durch Abstandselemente (28) verbunden sind, daß das eine (24) der Stangenelemente mit Kontaktschellen (34) versehen ist, von welchen erste Kontaktorgane wegstehen, und daß vom zweiten Stangenelement (26) in Richtung zum ersten Stangenelement (24) hin Federelemente (42) wegstehen, von welchen jedes mit mindestens einem zweiten Kontaktorgan versehen ist, wobei zusammengehörende Kontaktorgan-Paare mit ihren Kontaktflächen (40, 58) mittels des zugehörigen Federelementes (42) gegeneinander gedrückt werden.

2. Kontakteinrichtung nach Anspruch 1,
**dadurch gekennzeichet,**
daß das erste Stangenelement (24) einen Kern (30) aus einem elektrisch gut leitenden Material und eine am Kern (30) eng anliegende Hülle (32) aus chemisch beständigem Material aufweist.

3. Kontakteinrichtung nach Anspruch 1,
**dadurch gekennzeichnet,**
daß das erste Stangenelement (24) einen kreisrunden Querschnitt besitzt und daß jede Kontaktschelle (34) als am ersten Stangenelement (24) elektrisch leitend fixierte Hülse ausgebildet ist, von der tangential das entsprechende erste Kontaktorgan als Lasche (36) wegsteht, die mit der zugehörigen Kontaktfläche (40) ausgebildet ist.

4. Kontaktiereinrichtung nach Anspruch 3,
**dadurch gekennzeichnet,**
daß die/jede Lasche (36) auf der dem entsprechenden Federelement (42) zugewandten Seite mit einer die Kontaktfläche (40) aufweisenden Erhebung (38) ausgebildet ist.

5. Kontaktiereinrichtung nach Anspruch 3 oder 4,
**dadurch gekennzeichnet,**
daß die/jede Lasche (36) auf der vom zweiten Stangenelement (26) abgewandten Seite vom ersten Stangenelement (24) wegsteht.

6. Kontaktiereinrichtung nach Anspruch 1,
**dadurch gekennzeichnet,**
daß das/jedes Federelement (42) ein Federblech (44) aufweist, von dem mindestens ein das entsprechende zweite Kontaktorgan bildender Kontaktstift (56) wegsteht, dessen vom Federblech (44) entfernte Stirnfläche die entsprechende Kontaktfläche (58) bildet.

7. Kontaktiereinrichtung nach Anspruch 6,
**dadurch gekennzeichnet,**
daß das/jedes Federblech (44) am zweiten Stangenelement (26) festgeschraubt ist.

8. Kontaktiereinrichtung nach Anspruch 6 und 7,
**dadurch gekennzeichnet,**
daß das/jedes Federblech (44) an einem vom ersten Stangenelement (24) abgewandten Befestigungsabschnitt des zweiten Stangenelementes (26) festgeschraubt ist und mit seinem vom Befestigungsabschnitt abgewandten freien Endabschnitt (54), von dem der mindestens eine Kontaktstift (56) zum zugehörigen Kontaktorgan des ersten Stangenelementes (24) hin wegsteht, über die vom zweiten Stangenelement (26) abgewandte Seite des ersten Stangenelementes (24) vorsteht.

9. Kontaktiereinrichtung nach einem der vorhergehenden Ansprüche,
**dadurch gekennzeichnet,**
daß das zweite Stangenelement (26) einen viereckigen Vollquerschnitt aufweist.

10. Kontaktiereinrichtung nach einem der Ansprüche 6 bis 9,
**dadurch gekennzeichnet,**
daß das Federblech (44) zum Beabstanden der Kontaktorgane des entsprechenden Kontaktorgan-Paares mit einem Betätigungsorgan (62) ausgebildet ist.

11. Kontaktiereinrichtung nach einem der vorhergehenden Ansprüche,
**dadurch gekennzeichnet,**
daß sie (22) mit Ausnahme der Kontaktflächen (40, 58) der Kontaktorgane mit einer elektrisch isolierenden Beschichtung (66) versehen ist.
